# EUROPÄISCHE PATENTANMELDUNG

(11) **EP 3 671 226 A1**
(43) Veröffentlichungstag der Anmeldung: **24.06.2020**
(21) Anmeldenummer: 18213419.7
(22) Anmeldetag: 18.12.2018
(51) Int. Cl.: G01R 15/14

(54) **STROMMESSVORRICHTUNG ZUR MESSUNG EINES ELEKTRISCHEN STROMS IN EINEM LEITER**

(71) Anmelder: Siemens Aktiengesellschaft, 80333 München (DE)
(72) Erfinder: Hoffmann, Ingolf, 91074 Herzogenaurach (DE); Dietz, Gunnar, 90478 Nürnberg (DE); Itzke, Alexander, 90443 Nürnberg (DE); Weiss, Roland, 91058 Erlangen (DE)

(57) **Zusammenfassung**

Strommessvorrichtung zur Messung eines elektrischen Stroms in einem Leiter, umfassend eine Mehrzahl von Magnetfeldsensoren, welche in Umfangsrichtung auf einem im Wesentlichen ringförmigen Trägerelement um eine vom Trägerelement umgriffene Öffnung zur Aufnahme des Leiters angeordnet sind, wobei das Trägerelement eine sich von einem äußeren Rand des Trägerelements zu der innenliegenden Öffnung erstreckende Durchbrechung aufweist.

## Beschreibung

Die Erfindung betrifft eine Strommessvorrichtung zur Messung eines elektrischen Stroms in einem Leiter, umfassend eine Mehrzahl von Magnetfeldsensoren, welche in Umfangsrichtung auf einem im Wesentlichen ringförmigen Trägerelement um eine vom Trägerelement umgriffene Öffnung zur Aufnahme des Leiters angeordnet sind.

In vielen technischen Anwendungen ist das Messen eines elektrischen Stromes erforderlich. In Frequenzumrichter-Anordnungen stellt sich dabei das Problem, dass der zu messende Strom zwischen einzelnen Komponenten der Anordnung gemessen werden muss, wobei der Strom ein mit Oberwellen überlagerter Gleichstrom ist. Bei größeren Frequenzumrichter-Anordnungen kann sich das Problem stellen, dass ihr Ausgangsstrom über ein Bündel von Leitungen geführt wird, wobei der Leiterstrom außerhalb des Frequenzumrichters gemessen werden muss. Dabei kann beispielsweise eine Grundwelle des Stromes in einem Frequenzbereich zwischen 0 Hz und 600 Hz liegen. Neben dem Auftreten von Mischformen aus Gleichstrom und Wechselstrom besteht ein weiteres Problem bei der Strommessung in der Messung von Strompulsen, welche beispielsweise bei der Qualifizierung und/oder Inbetriebnahme von schnellschaltenden Leistungselektronikkomponenten wie Halbleitermodulen oder als Bremseinheiten verwendeten elektrischen Maschinen auftreten können.

Bekannte Verfahren zur Messung des Stromes umfassen beispielsweise die Integration von Shunts in den Anlagen. Diese haben jedoch den Nachteil, dass die Messung nicht permanent mit einer hohen Auflösung durchgeführt werden kann, da sich der Shunt während der Messung erwärmt. Weiterhin kann durch die Induktivität des Shunts eine Beeinflussung der Strommessung auftreten. Die Messung mit Shunts kann auch bei einem Bündel von Leitungen durchgeführt werden, wobei die Shunts mit Zusatzkabeln an die den jeweiligen zu messenden Strom führenden Stromschienen bzw. Leitungsbündel verbunden werden müssen.

Eine weitere Möglichkeit zur Messung von Strömen stellen Sensoren dar, welche eine um den stromführenden Leiter anzuordnende Spule umfassen. Diese haben jedoch den Nachteil, dass sich zeitlich nicht ändernde Ströme bzw. Stromanteile, das heißt Gleichströme bzw. Gleichanteile, durch sie nicht gemessen werden können. Weiterhin können bei induktiv messenden Stromsensoren, beispielsweise bei um den entsprechenden Leiter anzuordnenden Stromzangen, Temperaturbeschränkungen bestehen, welche insbesondere bei hohen Strömen nur einen kurzen zeitlichen Einsatz und somit keine dauerhafte oder längerfristige Messung ermöglichen.

Um sowohl Gleichströme als auch Wechselströme in einem vergleichsweise großen Temperaturbereich messen zu können, ist es bekannt, eine Mehrzahl von Magnetfeldsensoren ringförmig um den stromführenden Leiter anzuordnen. Bei der Verwendung von Magnetfeldsensoren, welche auch sich zeitlich nicht ändernde Magnetfelder messen können, wird somit eine Strommessung sowohl von Gleichstrom als auch von Wechselstrom durch die vom Strom erzeugten Magnetfelder ermöglicht.

Strommessungen mit um einen, den zu messenden Strom führenden Leiter angeordneten Magnetfeldsensoren werden in R. Weiss et al., IEEE T. Ind. Electron. 64, 6, 4903-4909 (2017) sowie in R. Weiss et al., DC Microgrids (ICDCM), 2017 IEEE Second Conference on, 166 - 170 (2017) beschrieben.

Eine um einen Leiter angeordnete Magnetfeldsensoren umfassende Strommessvorrichtung ist in der Druckschrift WO 2016/156392 A1 beschrieben. Die dort beschriebene Strommessvorrichtung umfasst mehrere Magnetfeldsensoren zur Erfassung des von dem zu messenden Strom erzeugten Magnetfelds. Weiterhin umfasst die Strommessvorrichtung auch eine Kompensationsspule, welche um den Leiter sowie die Magnetfeldsensoren angeordnet ist. Mit Hilfe einer Regeleinrichtung der Stromvorrichtung kann ein elektrischer Kompensationsstrom in der Kompensationsspule eingestellt werden, so dass das von dem Leiter erzeugte Magnetfeld im Bereich der Magnetfeldsensoren im Wesentlichen oder gänzlich kompensiert wird. Dies ermöglicht es, dass mit den Magnetfeldsensoren stets im Bereich kleiner Magnetfelder gemessen wird, unabhängig von der Größe des von dem Strom im Leiter erzeugten Magnetfeldes. Die Stromstärke kann dabei über den in der Kompensationsspule zur Kompensation des Magnetfeldes fließenden Kompensationsstrom bestimmt werden.

Bei einer derartigen Strommessvorrichtung stellt sich jedoch das Problem, dass die Magnetfeldsensoren nur umständlich um den Leiter, welcher den zu messenden Strom führt, angeordnet werden können. Da Strommessvorrichtungen jedoch insbesondere bei der Inbetriebnahme oder bei der Überprüfung von leistungselektronischen Geräten oder Anlagen zum Einsatz kommen und nicht permanent installiert werden müssen, ist es wünschenswert, wenn eine Strommessvorrichtung möglichst einfach zu montieren und zu demontieren ist und eine Montage in oder an einer Vielzahl von verschiedenen leistungselektronischen Geräten oder Anlagen möglich ist.

Der Erfindung liegt daher die Aufgabe zugrunde, eine Strommessvorrichtung zur Messung eines elektrischen Stroms in einem Leiter anzugeben, welche sowohl für die Messung von Gleichspannung als auch von Wechselspannung geeignet ist und welche eine schnelle und einfache Montage an einer Vielzahl von verschiedenen stromführenden Leitern ermöglicht.

Zur Lösung dieser Aufgabe ist bei einer Strommessvorrichtung der eingangs genannten Art erfindungsgemäß vorgesehen, dass das Trägerelement eine sich von einem äußeren Rand des Trägerelements zu der innenliegenden Öffnung erstreckende Durchbrechung aufweist.

Das im Wesentlichen ringförmige Trägerelement kann beispielsweise plattenförmig sein und insbesondere eine kreisringförmige Form aufweisen, wobei das Trägerelement eine in diesem Fall ebenfalls kreisförmige Öffnung zur Aufnahme des Leiters umgreift. Es sind jedoch auch andere Formen des Trägerelements denkbar, beispielsweise eine hexagonale, eine oktogonale oder ähnliche Formen. Bevorzugt kann dabei der zur innenliegenden Öffnung weisende Umfang des Trägerelements dieselbe Form aufweisen wie der nach außen weisende Umfang bzw. der äußere Rand des Trägerelements. Die Magnetfeldsensoren können insbesondere auf einer der Seitenflächen des Trägerelements angeordnet sein. Auch eine Anordnung der Magnetfeldsensoren auf beiden Stirnflächen des Trägerelements ist möglich. Bei Anordnung des Leiters, in welchem ein Strom gemessen werden soll, im Inneren der vom Trägerelement umgriffenen Öffnung sind die auf einer oder beiden Stirnflächen angeordneten Sensoren um den Leiter angeordnet. Das Trägerelement kann insbesondere wenigstens eine Leitung umfassen, welche auf oder an dem Trägerelement angeordnet sind und welche mit wenigstens einem der Magnetfeldsensoren verbunden ist.

Die Durchbrechung, welche sich von dem äußeren Rand des Trägerelements zu der innenliegenden Öffnung erstreckt, ermöglicht es, das Trägerelement um einen Leiter herum anzuordnen, ohne dass der Leiter demontiert werden muss bzw. ohne dass die Strommessvorrichtung auf den Leiter aufgeschoben werden muss. Durch die erfindungsgemäß vorgesehene Durchbrechung kann die Strommessvorrichtung auch um einen Leiter herum angeordnet werden, während der Leiter zwischen zwei Komponenten verbunden ist und ein Aufschieben der Strommessvorrichtung über eine Stirnseite des Leiters nicht möglich ist.

Die Durchbrechung kann dabei eine sich in Umfangsrichtung des ringförmigen Trägerelements erstreckende Breite aufweisen, so dass der Leiter durch die Durchbrechung in die Öffnung geführt werden kann. Es ist jedoch auch möglich, dass die Durchbrechung keine oder keine nennenswerte Breite in Umfangsrichtung aufweist und nur eine Trennlinie darstellt, in welcher das im Wesentlichen ringförmige Trägerelement durchbrochen ist.

Die Durchbrechung ermöglicht es, die beiden Kanten des Trägerelements, welche an die Durchbrechung angrenzen, in unterschiedlichen axialen Richtungen, das heißt in entgegengesetzte Richtungen orthogonal zu einer der Stirnflächen des Trägerelements, auseinanderzuziehen, so dass der Leiter durch den dadurch entstehenden Spalt in die Öffnung geführt werden und die Strommessvorrichtung um den Leiter angeordnet werden kann. Abhängig davon, wie weit das Trägerelement auseinander gezogen wird, kann der entstehende Spalt deutlich größer sein als eine gegebenenfalls vorgesehene Breite der Durchbrechung, so dass auch eine Anordnung der Strommessvorrichtung um vergleichsweise breite Leiter oder Leiterbündel möglich ist.

Es ist auch möglich, dass das Trägerelement wenigstens eine weitere Durchbrechung aufweist, so dass das Trägerelement zwei Segmente aufweist, welche nach Anordnen des Leiters im Inneren der Öffnung zu dem im Wesentlichen ringförmigen Trägerelement zusammengesetzt werden können, so dass auf den jeweiligen Segmenten des Trägerelements angeordneten Magnetfeldsensoren im Wesentlichen ringförmig um den Leiter angeordnet sind.

Die Anordnung des Leiters im Inneren der Öffnung erfolgt bevorzugt derart, dass die radiale Richtung des Trägerelementes orthogonal oder im Wesentlichen orthogonal zu dem Leiter steht. Der Leiter kann dabei insbesondere im Mittelpunkt der Öffnung angeordnet sein. Durch den im Leiter geführten Strom wird ein Magnetfeld erzeugt, welches von den beispielsweise als Hall-Sensoren ausgeführten Magnetfeldsensoren gemessen werden kann. Aus den jeweiligen Messwerten der um den Leiter herum angeordneten Magnetfeldsensoren kann anschließend auf die Stromstärke des im Leiter schließenden Stromes geschlossen werden.

Erfindungsgemäß kann vorgesehen sein, dass das Trägerelement zumindest bereichsweise aus einem flexiblen Material, insbesondere aus Polyimid, besteht und/oder dass das Trägerelement eine flexible oder teilflexible Leiterplatte ist. Die Ausführung des Trägerelements als flexible Leiterplatte, auch Flexleiterplatte genannt, ermöglicht es dabei, auch wenigstens eine elektrische Leitung, welche die auf dem Trägerelement angeordneten Sensoren verbindet, als Leiterbahn direkt in das Trägerelement zu integrieren. Darüber hinaus wird durch die Ausführung des Trägerelements aus einem flexiblen Material bzw. als flexible oder teilflexible Leiterplatte ein axiales Auseinanderziehen des Trägerelements vereinfacht und somit eine möglichst weite Beabstandung der Enden des Trägerelements im Bereich der Durchbrechung ermöglicht. Dies vereinfacht das Anordnen des Trägerelements um den stromführenden Leiter bzw. ermöglicht es, möglichst große stromführende Leiter in der Öffnung des Trägerelementes anzuordnen, um den in diesen Leitern fließenden Strom zu messen.

In einer bevorzugten Ausgestaltung der Erfindung kann vorgesehen sein, dass das Trägerelement wenigstens einen sich in Umfangsrichtung erstreckenden Biegeabschnitt aufweist, in welchem eine radiale Breite und/oder eine Dicke des Trägerelements reduziert ist und/oder in dem eine oder mehrere wenigstens eine Biegelinie definierende Aussparungen vorgesehen sind. Durch das Vorsehen eines Biegeabschnittes, in welchem die sich in radialer Richtung des Trägerelements erstreckende Breite des Trägerelements reduziert ist, wird ein Verbiegen des Trägerelementes bei einem axialen Auseinanderziehen vereinfacht bzw. ein möglichst weite Auseinanderziehbarkeit des Trägerelementes erreicht.

Zusätzlich oder alternativ zu einer reduzierten radialen Breite kann in dem sich in Umfangsrichtung erstreckenden Biegeabschnitt auch eine Dicke des Trägerelements reduziert werden. Dabei kann beispielsweise die Dicke eines ein plattenförmiges Trägerelement bildenden Materials reduziert werden, wodurch ein Verbiegen des Trägerelements entlang des sich bevorzugt von einem äußeren Rand des Trägerelements zu der innenliegenden Öffnung erstreckenden Biegeabschnitts vereinfacht wird.

Erfindungsgemäß kann vorgesehen sein, dass das Trägerelement wenigstens einen starren, sich in Umfangsrichtung erstreckenden Bauteilbereich aufweist, wobei in dem Bauteilbereich wenigstens ein elektronisches Bauteil angeordnet ist. Durch das Vorsehen wenigstens eines starren Bauteilbereichs wird es ermöglicht, eine Verbiegung des Trägerelements bei einem axialen Auseinanderziehen in den Bereichen zu vermeiden, in denen wenigstens ein elektronisches Bauteil angeordnet ist. Dadurch können Beschädigungen des wenigstens einen elektronischen Bauteils und/oder der Verbindungen des wenigstens einen elektronischen Bauteils zu einem Kabel und/oder einer oder mehrerer als Leiterbahnen ausgebildeter Leitungen des Trägerelements vermieden werden.

Bei dem wenigstens einen elektronischen Bauteil kann es sich um einen der Magnetfeldsensoren handeln. Insbesondere kann vorgesehen sein, dass für jeden der Mehrzahl von Magnetfeldsensoren jeweils ein starrer Bauteilbereich vorgesehen ist, so dass eine Verbiegung des Trägerelementes in den Bereichen, in denen jeweils wenigstens einer der Magnetfeldsensoren angeordnet ist, vorteilhaft vermieden werden kann. Es ist auch möglich, dass es sich bei dem wenigstens einen elektronischen Bauteil um ein Bauteil einer Ansteuerungsschaltung und/oder einer Ausleseschaltung zur Ansteuerung bzw. zum Auslesen und/oder Auswerten der Sensorsignale handelt.

Erfindungsgemäß kann vorgesehen sein, dass die Mehrzahl von Magnetfeldsensoren gleichmäßig in Umfangsrichtung auf dem Trägerelement angeordnet ist, wobei die Durchbrechung von einem der Magnetfeldsensoren bezogen auf den Mittelpunkt der Öffnung um den Winkel α = 90°/ N versetzt ist, wobei N die Anzahl der Magnetfeldsensoren darstellt. Bei der gleichmäßigen Anordnung der Magnetfeldsensoren sind die Magnetfeldsensoren in Umfangsrichtung entsprechend um den Winkel β = 360°/ N versetzt. Die Winkel zwischen zwei Magnetfeldsensoren bzw. zwischen einem Magnetfeldsensor und der Durchbrechung können sich insbesondere auf die jeweils in radialer Richtung durch den Magnetfeldsensor bzw. die Durchbrechung verlaufenden Mittellinien beziehen.

Die Anordnung der Durchbrechung bei dem Winkel α = 90°/ N hat den Vorteil, dass eine von der Durchbrechung ausgehende Störung dem geringsten Effekt auf die Strommessung mittels der Strommessvorrichtung hat. Die analytische Herleitung dieser Winkelbeziehung kann der Veröffentlichung Nr. 2018J03461, http://www.prioartregister.com/ entnommen werden.

Durch die Durchbrechung kann beispielsweise aufgrund einer Leitungsführung im Bereich der Durchbrechung eine Störung entstehen. Aufgrund der Durchbrechung des Trägerelements ist eine Leitungsführung, beispielsweise einer mit wenigstens einem Magnetfeldsensor verbundenen Leitung, über die Durchbrechung hinweg nicht möglich. Dadurch kann im Bereich der Durchbrechung eine Asymmetrie der mit der mit dem wenigstens einen Magnetfeldsensor verbundenen Leitung vorliegen, wodurch ein störender Einfluss auf die Strommessung der Strommessvorrichtung entstehen kann. Durch die Anordnung der Durchbrechung in einer umfangsmäßigen Beabstandung um den Winkel α = 90°/ N wird der Einfluss einer derartigen Störung auf die Strommessung minimiert.

Erfindungsgemäß kann vorgesehen sein, dass die Strommessvorrichtung wenigstens einen randseitig am Trägerelement angeordneten Anschluss aufweist, insbesondere in einem der Durchbrechung gegenüberliegenden Bereich des Trägerelements. Wie vorangehend für die Durchbrechung beschrieben wurde, kann ein störender Einfluss auf die Strommessung auch im Bereich eines Anschlusses des Trägerelements, an dem beispielsweise mit den Magnetfeldsensoren und/oder mit einer Auswerteelektronik der Magnetfeldsensoren verbundene Leitungen nach außen geführt bzw. mit einem Stecker oder einer Buchse verbunden sein, entstehen. Dabei kann vorgesehen sein, dass der Anschluss in einem der Durchbrechung gegenüberliegenden Bereich des Trägerelements angeordnet ist. Dies hat insbesondere bei der Verwendung einer geraden Anzahl N von gleichmäßig angeordneten Magnetfeldsensoren den Vorteil, dass der Anschluss sich ebenfalls in Bezug zu dem nächstliegenden Magnetfeldsensor um den Winkel α versetzt befindet, so dass auch eine aufgrund des Anschlusses entstehende Störung auf die Strommessung nur den geringstmöglichen Einfluss hat. Unabhängig von der Anzahl und der Anordnung der Magnetfeldsensoren bietet die Anordnung des Anschlusses in einem der Durchbrechung gegenüberliegenden Bereich den Vorteil, dass bei einem axialen Auseinanderziehen des Trägerelements in diesem Bereich nur die geringste Positionsänderung auftritt, was einen Anschluss bzw. eine Verbindung des Trägerelements an ein oder mehrere Peripheriegeräte erleichtert.

In einer bevorzugten Ausgestaltung der Erfindung kann vorgesehen sein, dass an dem Trägerelement eine ringförmige, sich in Umfangsrichtung um die Öffnung des Trägerelements erstreckende, mehrere Windungen umfassende Kompensationsspule angeordnet ist, wobei sich die Kompensationsspule entlang des Trägerelements von einem ersten Ende zu einem zweiten Ende erstreckt, wobei das erste Ende und das zweite Ende jeweils auf einer gegenüberliegenden Seite der Durchbrechung angeordnet sind. Dabei kann beispielsweise vorgesehen sein, dass an dem ersten Ende zwei Anschlüsse der Windungen der Kompensationsspule angeordnet sind und dass am zweiten Ende eine Umkehr der Windungsrichtung erfolgt. Die Kompensationsspule kann insbesondere toroidförmig sein bzw. als sogenannte Rogowski-Spule ausgeführt werden.

Eine Umkehr der Windungsrichtung an dem zweiten Ende der Spule kann als ein Wechsel zwischen einem Verlauf der Kompensationsspule in Umfangsrichtung im Uhrzeigersinn um die Öffnung zu einem Verlauf gegen den Uhrzeigersinn oder umgekehrt ausgeführt sein. Dabei können beispielsweise die Windungen eines vom zweiten Ende zum ersten Ende führenden Rückleitungsabschnitts in die Zwischenräume eines vom ersten Ende zum zweiten Ende führenden Hinleitungsabschnitts der Spule gewickelt sein. Dabei wird der Windungssinn beibehalten, damit sich die von Hinleitungsabschnitt und Rückleitungsabschnitt erzeugten Magnetfelder konstruktiv überlagern.

Es ist auch möglich, dass vom zweiten Ende zum ersten Ende ein nicht gewickelter Abschnitt des Leiters mittig durch die Spule zum ersten Ende zurückgeführt wird. Auch ist es möglich, dass von dem ersten Ende und dem zweiten Ende der Spule jeweils ein Leiter durch die Mitte der Spule zurückgeführt bzw. als Rückleitungsabschnitt zwischen die Windungen eines Hinleitungsabschnitts gewickelt und mit einer Ansteuerungselektronik und/oder einem Anschluss in einem Bereich, insbesondere in einem der Durchbrechung gegenüberliegenden Bereich, verbunden wird.

Die Kompensationsspule kann in Umfangsrichtung insbesondere die gleiche Geometrie aufweisen wie das Trägerelement, so dass der Verlauf der Kompensationsspule in Umfangsrichtung der Ausdehnung des Trägerelementes in Umfangsrichtung entspricht. Die Windungen der Kompensationsspule können einen kreisförmigen oder im Wesentlichen kreisförmigen Querschnitt aufweisen. Es ist auch möglich, dass die Windungen einen davon abweichenden Querschnitt, beispielsweise einen hexagonalen oder orthogonalen Querschnitt, aufweisen.

Für die Kompensationsspule kann erfindungsgemäß vorgesehen sein, dass sie zu beiden Seiten der Durchbrechung bereichsweise eine höhere Windungsdichte als im restlichen, wenigstens die Hälfte der Länge der Kompensationsspule umfassenden und sich mittig zwischen den Enden der Kompensationsspule erstreckenden Bereich der Kompensationsspule aufweist. Durch eine Erhöhung der Windungsdichte der Kompensationsspule im Bereich der Durchbrechung, das heißt zu beiden Seiten der Durchbrechung bzw. am ersten Ende und am zweiten Ende der Spule, kann eine Kompensation der im Bereich der Durchbrechung vorhandenen Unterbrechung der Spule bzw. einer Kompensation der durch die Windungsführung am ersten Ende und am zweiten Ende der Spule entstehenden, gegebenenfalls störend auf eine Strommessung wirkenden Effekte erreicht werden. Die Windungsdichte kann zu beiden Seiten der Durchbrechung beispielsweise in einem Bereich von 5° oder 10° oder 15° erhöht werden. Die Windungsdichte kann dabei sprungartig oder kontinuierlich erhöht werden, wobei bei einer kontinuierlichen Erhöhung die Windungen umso näher aneinanderrücken, je mehr sie an der Durchbrechung angeordnet sind.

Erfindungsgemäß kann vorgesehen sein, dass die Kompensationsspule zumindest im Wesentlichen toroidförmig ist, wobei die Windungen der Kompensationsspule durch Aussparungen des Trägerelements geführt sind und/oder um das Trägerelement gewickelt sind. Das Trägerelement kann Aussparungen aufweisen, welche beispielsweise am inneren und am äußeren Rand des Trägerelements angeordnet sind, wobei durch die Aussparungen der Leiter der Kompensationsspule gewickelt wird. Es ist auch möglich, dass die Aussparungen als etwas vom inneren bzw. äußeren Rand des Trägerelements beabstandete Durchgangöffnungen ausgeführt sind, wobei der Leiter der Kompensationsspule durch diese Löcher geführt ist. Der Leiter kann dabei im Uhrzeigersinn und/oder gegen den Uhrzeigersinn um ein kreisringförmiges Trägerelement gewickelt werden, so dass sich eine toroidförmige Form der Kompensationsspule ergibt.

Erfindungsgemäß kann vorgesehen sein, dass auf den gegenüberliegenden Stirnseiten des Trägerelements jeweils wenigstens ein flexibles, ringsegmentförmiges Spulenträgerelement angeordnet ist, wobei die Kompensationsspule um die Spulenträgerelemente gewickelt ist, und/oder dass die Kompensationsspule von einem flexiblen, schlauchförmigen Abdeckelement umschlossen ist, welches sich in Umfangsrichtung von dem ersten Ende zum zweiten Ende der Kompensationsspule erstreckt. Auf den gegenüberliegenden Stirnseiten des Trägerelements kann jeweils wenigstens ein flexibles, ringsegmentförmiges Spulenträgerelement angeordnet sein, wobei die Ringsegmentform des Spulenträgerelements der Ringform des Trägerelements entspricht, so dass insbesondere die Stirnseiten jeweils durch die Spulenträgerelemente komplett abgedeckt werden können. Die Spulenträgerelemente können beispielsweise aus einem flexiblen und isolierenden Material, beispielsweise Silikon, bestehen. Es ist möglich, dass die Spulenträgerelemente durch ein Eingießen des Trägerelements in das Material gebildet werden.

Bei einem Trägerelement, bei dem an jeder Stirnseite ein Spulenträgerelement angeordnet ist, kann vorgesehen sein, dass das Spulenträgerelement ebenfalls eine mit der Durchbrechung des Trägerelements vollständig überlappende Durchbrechung aufweist, so dass ein axiales Auseinanderziehen des Trägerelements weiterhin möglich ist. Es ist auch möglich, dass auf jeder Stirnseite in Umfangsrichtung mehrere Spulenträgerelemente angeordnet sind, wobei zwei benachbarte Spulenträgerelemente im Bereich der Durchbrechung jeweils an diese angrenzen können, so dass ebenfalls ein axiales Auseinanderziehen des Trägerelementes ermöglicht wird. Die Spulenträgerelemente können jeweils eine insbesondere im Wesentlichen halbkreisförmige Querschnittsfläche aufweisen, insbesondere derart, dass der aus Trägerelement sowie zu beiden Seiten an den Stirnflächen des Trägerelements angeordneten Spulenträgerelementen gebildete Querschnitt zumindest im Wesentlichen kreisförmig ist. Dies hat den Vorteil, dass eine um das Trägerelement und die Spulenträgerelemente gewickelte und an diesen anliegende Kompensationsspule Windungen mit kreisförmigem Querschnitt aufweist.

Zusätzlich oder alternativ dazu kann die Kompensationsspule von einem flexiblen, schlauchförmigen Abdeckelement umschlossen sein, welches sich in Umfangsrichtung von dem ersten Ende zum zweiten Ende der Kompensationsspule bzw. von der einen Seite der Durchbrechung am Trägerelement zu der anderen Seite der Durchbrechung erstreckt und die Kompensationsspule insbesondere über ihre gesamte Länge umschließt. Das schlauchförmige Abdeckelement umhüllt somit die Kompensationsspule sowie das Trägerelement, an dem die Kompensationsspule angeordnet ist und schützt das Trägerelement bzw. die Kompensationsspule vor Beschädigungen. Weiterhin kann das schlauchförmige Abdeckelement aus einem isolierenden Material, beispielsweise einem Kunststoff, bestehen und somit als Isolierung dienen, so dass die Kompensationsspule nach außen hin isoliert ist.

Erfindungsgemäß kann vorgesehen sein, dass an dem Trägerelement im Bereich der Durchbrechung ein bewegbares Verschlusselement angeordnet ist, welches zwischen einer Offenstellung und einer Schließstellung bewegbar ist, wobei in der Offenstellung die die Durchbrechung begrenzenden Kanten des Trägerelements relativ zueinander bewegbar sind und in der Schließstellung die die Durchbrechung begrenzenden Kanten des Trägerelements relativ zueinander fixiert sind. Das Verschlusselement kann dabei beispielsweise in Umfangsrichtung zwischen der Offenstellung und der Schließstellung bewegbar sein. Das Verschlusselement kann dazu das Trägerelement, insbesondere das Trägerelement und eine am Trägerelement angeordnete Kompensationsspule und/oder ein gegebenenfalls vorhandenes Abdeckelement, bereichsweise, das heißt in einem Abschnitt in Umfangsrichtung des Trägerelements, umgreifen.

Ein derartiges Trägerelement blockiert in Schließstellung, das heißt, wenn es über die Durchbrechung geschoben ist, eine Bewegung der die Durchbrechung begrenzenden Kanten des Trägerelements relativ zueinander. Umgekehrt ermöglicht ein derartig ausgeführtes Trägerelement, dass die die Durchbrechung begrenzenden Kanten relativ zueinander bewegt werden, wenn das Trägerelement in die Offenstellung, das heißt derart bewegt wird, dass das Verschlusselement gänzlich neben der Durchbrechung angeordnet ist. Durch die Fixierung der die Durchbrechung begrenzenden Kanten des Trägerelements in der Schließstellung des Verschlusselements wird ein unbeabsichtigtes Öffnen bzw. ein unbeabsichtigtes Auseinanderziehen des Trägerelementes vermieden und eine stabile und sichere Anordnung des Trägerelements um einen im Inneren der Öffnung angeordneten Leiter ermöglicht.

Es kann vorgesehen sein, dass das Verschlusselement in der Schließstellung verrastet, beispielsweise in wenigstens einer Aussparung eines vom Verschlusselement umgriffenen Abdeckelements. Das Verschlusselement kann auf das Trägerelement bzw. auf eine am Trägerelement angeordnete Kompensationsspule und/oder ein gegebenenfalls vorhandenes Abdeckelement aufgesteckt sein und/oder die die Durchbrechung begrenzenden Kanten können formschlüssig und/oder kraftschlüssig in das Verschlusselement einsteckbar sein.

In einer bevorzugten Ausgestaltung der Erfindung kann vorgesehen sein, dass das Trägerelement wenigstens eine weitere, sich von einem äußeren Rand des Trägerelements zu der innenliegenden Öffnung erstreckende Durchbrechung aufweist, wobei an der wenigstens einen weiteren Durchbrechung jeweils ein weiteres Verschlusselement angeordnet ist. Durch die Durchbrechung und die weitere Durchbrechung wird das Trägerelement in zwei Segmente geteilt. Bei einem Trägerelement, an dem eine Kompensationsspule angeordnet ist, kann auch die Kompensationsspule in zwei Spulensegmente geteilt sein, wobei jeweils eines der Spulensegmente der Kompensationsspule an einem der Segmente des Trägerelements angeordnet ist. Durch ein an der Durchbrechung angeordnetes Verschlusselement sowie durch das an der wenigstens einen weiteren Durchbrechung jeweils angeordnete weitere Verschlusselement können die Segmente des Trägerelements voneinander getrennt werden, wenn die Verschlusselemente jeweils in Offenstellung bewegt werden. Entsprechend können die Segmente des Trägerelements aneinander fixiert werden, wenn die Verschlusselemente jeweils in Schließstellung bewegt werden.

Erfindungsgemäß kann vorgesehen sein, dass das weitere Verschlusselement oder die weiteren Verschlusselemente jeweils wenigstens ein elektrisches Verbindemittel aufweisen, welches dazu ausgebildet ist, in Schließstellung des jeweiligen Verschlusselements zwei benachbarte Spulensegmente einer Kompensationsspule der Strommessvorrichtung elektrisch zu verbinden. Die Kompensationsspule einer Strommessvorrichtung, deren Trägerelement mehr als eine Durchbrechung hat, muss in mehrere getrennte Spulensegmente unterteilt sein, damit ein Segment des Trägerelements zwischen der Durchbrechung und der weiteren Durchbrechung entnommen und die Strommessvorrichtung um den Leiter herum angeordnet werden kann. Eine elektrische Verbindung zwischen den Spulensegmenten erfolgt in diesem Fall durch das elektrische Verbindemittel des weiteren Verschlusselements, wobei das elektrische Verbindemittel derart ausgeführt ist, dass es zwei benachbarte Spulensegmente der Kompensationsspule elektrisch miteinander verbindet, wenn es in seiner Schließstellung angeordnet ist. Auf diese Weise können die Leiter der mehreren Spulensegmente der Kompensationsspule miteinander verbunden werden.

Weitere Vorteile und Ausgestaltungen der Erfindung ergeben sich aus den im Folgenden beschriebenen Ausführungsbeispielen sowie anhand der Zeichnungen. Dabei zeigen:
- Fig. 1: eine schematische Darstellung eines ersten Ausführungsbeispiels einer erfindungsgemäßen Strommessvorrichtung,
- Fig. 2: eine weitere schematische Darstellung des ersten Ausführungsbeispiels einer erfindungsgemäßen Strommessvorrichtung,
- Fig. 3: eine schematische Darstellung eines Verschlusselements des ersten Ausführungsbeispiels einer erfindungsgemäßen Strommessvorrichtung,
- Fig. 4: eine schematische Darstellung eines zweiten Ausführungsbeispiels einer erfindungsgemäßen Strommessvorrichtung,
- Fig. 5: eine schematische Darstellung eines dritten Ausführungsbeispiels einer erfindungsgemäßen Strommessvorrichtung, und
- Fig. 6: eine Schnittansicht eines vierten Ausführungsbeispiels einer erfindungsgemäßen Strommessvorrichtung.

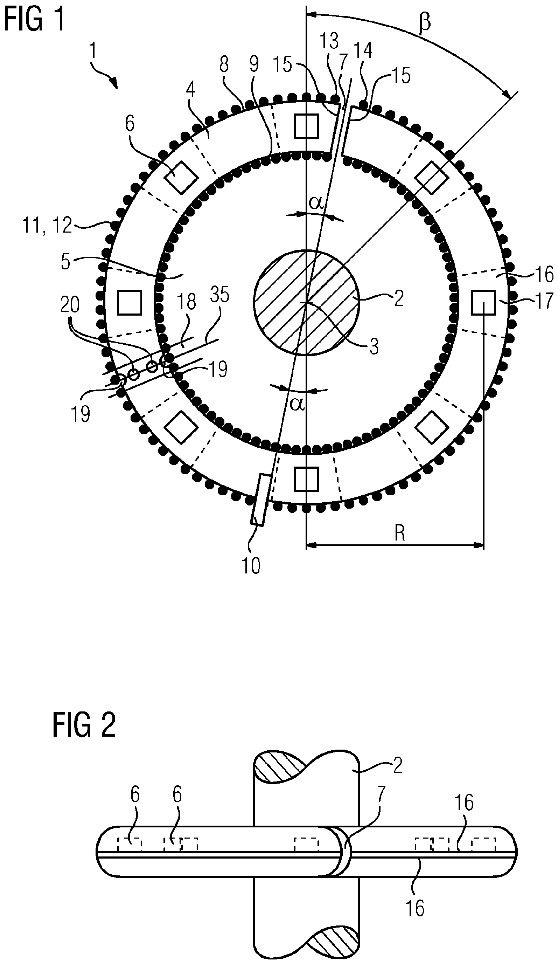

Fig. 1 zeigt ein erstes Ausführungsbeispiel einer erfindungsgemäßen Strommessvorrichtung 1. Die Strommessvorrichtung 1 dient zur Messung eines Stromes in einem stromdurchflossenen Leiter 2, welcher im Mittelpunkt 3 einer von einem Trägerelement 4 der Strommessvorrichtung 1 umgriffenen Öffnung 5 angeordnet ist. Um den Leiter 2 herum ist auf dem ringförmigen Trägerelement 4 eine Mehrzahl von Magnetfeldsensoren 6 angeordnet.

In diesem Ausführungsbeispiel umfasst die Mehrzahl von Magnetfeldsensoren 6 eine Anzahl N = 8 Magnetfeldsensoren 6. Die Magnetfeldsensoren 6 dienen der Messung eines Magnetfeldes, welches durch den im Leiter 2 fließenden Strom erzeugt wird. Die Magnetfeldsensoren 6 können beispielsweise als Hall-Sensoren ausgeführt sein, so dass ein zeitlich konstantes und/oder ein sich zeitlich änderndes Magnetfeld, mithin also ein Wechselstrom oder ein Gleichstrom oder eine Überlagerung eines Gleichstromes und eines Wechselstroms im Leiter 2 durch die Strommessvorrichtung 1 gemessen werden können. Die Magnetfeldsensoren 6 sind in diesem Ausführungsbeispiel gleichmäßig in Umfangsrichtung um den Leiter 2 angeordnet, das heißt, die Magnetfeldsensoren 6 sind jeweils bezogen auf den Mittelpunkt 3 der Öffnung um den Winkel β = 360°/ N = 45° voneinander versetzt.

Das Trägerelement 4 umfasst eine Durchbrechung 7, welche sich von einem äußeren Rand 8 des Trägerelements zu einem inneren Rand 9 des Trägerelements 4, wobei der innere Rand 9 an die vom Trägerelement 4 umgriffene Öffnung 5 angrenzt, erstreckt. Die Durchbrechung 7 bzw. eine in radialer Richtung verlaufende Mittellinie der Durchbrechung 7 ist in Umfangsrichtung von der in radialer Richtung verlaufenden Mittellinie eines der Magnetfeldsensoren 6 um den Winkel α = 90°/ N = 11,25° versetzt. Eine um den Winkel α = 90°/ N versetzte Durchbrechung erzeugt einen minimalen Störeinfluss auf die Magnetfeldsensoren 6 bei der Messung des Stromes im Leiter 2.

Aufgrund der Durchbrechung 7 können beispielsweise auf dem Trägerelement 4 angeordnete und als Leiterbahnen (hier nicht dargestellt) ausgebildete Leitungen, welche die Magnetfeldsensoren 6 untereinander und/oder mit einem Anschluss 10 verbinden, nicht kreisförmig weitergeführt werden, so dass an der Durchbrechung 7 selbst sowie im Bereich neben der Durchbrechung 7 auf dem Trägerelement 4 keine bzw. eine andere Leitungsführung erforderlich ist als auf dem Rest des Trägerelementes 4. Aufgrund dieser veränderten Leitungsführung kann eine Beeinflussung der Magnetfeldmessung durch die Magnetfeldsensoren 6, respektive der Strommessung durch die Strommessvorrichtung 1, erfolgen, welche jedoch durch die Anordnung der Durchbrechung 7 im Winkel α = 90°/ N zu einem der Magnetfeldsensoren 6 minimiert werden kann.

Ebenso kann durch die Leitungsführung im Bereich des Anschlusses 10 eine Störung erzeugt werden, weshalb der Anschluss 10 in diesem Ausführungsbeispiel gegenüberliegend zur Durchbrechung 7 angeordnet ist. Aufgrund der geraden Anzahl N = 8 der Magnetfeldsensoren 6 sowie ihrer gleichmäßigen Anordnung in Umfangsrichtung um den Leiter 2 ist auch der Anschluss 10 von dem nächstliegenden Magnetfeldsensor 6 in Umfangsrichtung um den Winkel α beabstandet.

Weiterhin ist an dem Trägerelement 4 eine Kompensationsspule 11 angeordnet, deren Windungen 12 um den äußeren Rand 8 und dem inneren Rand 9 des Trägerelementes 4 gewickelt sind. Die Kompensationsspule 11 erstreckt sich dabei von einem ersten Ende 13 in Umfangsrichtung auf dem Trägerelement 4 zu einem zweiten Ende 14, wobei das erste Ende 13 und das zweite Ende 14 jeweils an einer an die Durchbrechung 7 angrenzende Kante 15 des Trägerelements 4 angeordnet sind. Die Durchbrechung 7 wird somit nicht von der Kompensationsspule 11 bedeckt. Vorteilhaft befindet sich bei dieser Anordnung der der Durchbrechung 7 entsprechende Spalt in der Kompensationsspule 11 ebenfalls um den Winkel α von einem der Magnetfeldsensoren 6 versetzt.

Die Kompensationsspule 11 kann dabei so gewickelt werden, dass die beiden Anschlüsse der Kompensationsspule 11 im Bereich des Anschlusses 10 liegen. Dies kann beispielsweise dadurch erreicht werden, dass am ersten Ende 13 und am zweiten Ende 14 jeweils ein rückzuführender Anteil des die Windungen 12 bildenden Leiters durch das Innere der Kompensationsspule 11, beispielsweise als eine Leiterbahn auf dem Trägerelement 4, zum Anschluss 10 geführt werden. Alternativ dazu ist es möglich, dass der Leiter der Kompensationsspule 11 nicht im Inneren der Kompensationsspule 11 langgeführt wird, sondern in gleicher Windungsrichtung zwischen die vom Anschluss 10 zum ersten Ende 13 bzw. zum zweiten Ende 14 gewickelten Windungen 12 gewickelt und somit vom ersten Ende 13 bzw. zweiten Ende 14 zum Anschluss 10 zurückgeführt werden kann.

In der Kompensationsspule 11 kann ein Kompensationsstrom eingeprägt werden, welcher ein Magnetfeld erzeugt, welches das durch den im Leiter 2 fließenden Strom erzeugte Magnetfeld wenigstens teilweise kompensiert. Dadurch wird in den Magnetfeldsensoren 6 ein Magnetfeld gemessen, welches geringer als das vom im Leiter 2 fließenden Strom erzeugte Magnetfeld ist. Dies ermöglicht es, mit Hilfe der Magnetfeldsensoren 6 Ströme in verschiedenen Größenordnungen im Leiter 2 messen zu können.

Eine Bestimmung des im Leiter 2 fließenden Stromes kann dabei in Abhängigkeit des Kompensationsstroms erfolgen. Zur Einspeisung des Kompensationsstromes in die Kompensationsspule 11 und/oder zur Messung bzw. zur Auswertung der von den Magnetfeldsensoren 6 erzeugten Messsignale wird die Strommessvorrichtung 1 mit einem an den Anschluss 10 angeschlossenen Peripheriegerät (nicht dargestellt) verbunden.

Das Trägerelement 4 ist in diesem Ausführungsbeispiel als flexible Leiterplatte ausgeführt. Die flexible Leiterplatte kann dabei zumindest bereichsweise aus einem flexiblen Material wie Polyimid bestehen, so dass ein Auseinanderziehen des Trägerelements 4 in axialer Richtung, welche in Fig. 1 der Richtung orthogonal zur Zeichenebene entspricht, ermöglicht wird. Durch ein derartiges Auseinanderziehen können die an die Durchbrechung 7 angrenzenden Kanten 15 des Trägerelementes 4 in axialer Richtung voneinander beabstandet werden, so dass das Trägerelement 4 bzw. die Strommessvorrichtung 1 um einen Leiter 2 angeordnet werden kann. Dies ist insbesondere bei einem Leiter 2 möglich, welcher beispielsweise zwischen zwei Komponenten eines Gerätes oder einer Anlage verbunden ist, so dass ein Aufstecken der Strommessvorrichtung über eine Stirnseite des Leiters 2 nicht möglich ist.

Durch die Durchbrechung 7 kann die Strommessvorrichtung 1 um verschiedene, in Schaltungsanordnungen oder leistungselektronischen Anlagen fest verbaute Leiter 2 wie Kabel, Kabelbündel und/oder Stromschienen angeordnet werden, ohne dass diese vorher demontiert werden müssen. Dies ermöglicht insbesondere eine Messung eines Stromes direkt an stromführenden Leitern 2, ohne dass ein Abschalten des Stromflusses durch den Leiter 2 vor der Montage der Strommessvorrichtung 1 erforderlich ist.

Die auf dem Trägerelement 4 angeordneten Magnetfeldsensoren 6 und die Kompensationsspule 11 können über den Anschluss 10 an ein oder mehrere Peripheriegeräte angeschlossen werden. Über die Peripheriegeräte kann beispielsweise eine Auswertung der Messergebnisse der Magnetfeldsensoren 6, eine Ansteuerung und/oder eine Speisung der Magnetfeldsensoren 6 sowie eine Auswertung und/oder eine Einspeisung eines Kompensationsstroms in die Kompensationsspule 11 erfolgen.

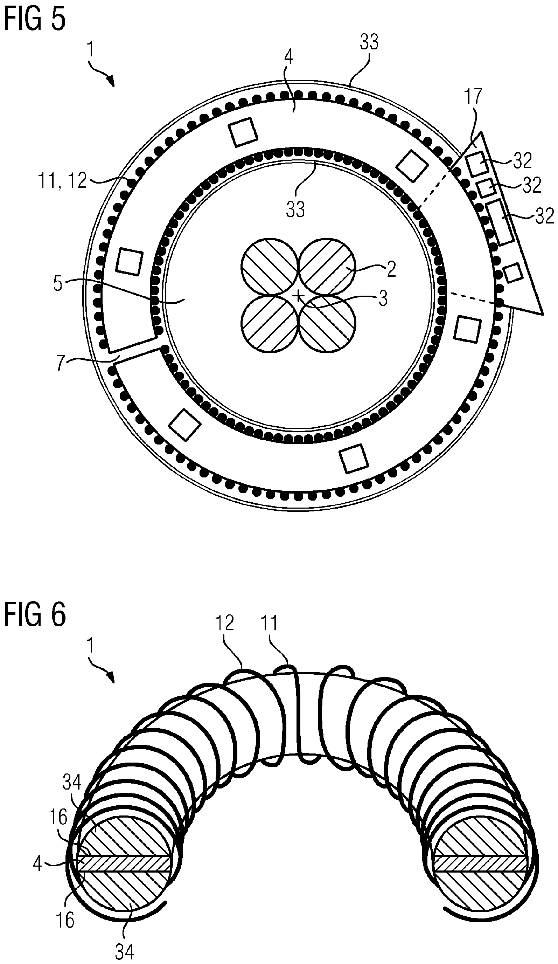

Die Anordnung der Strommessvorrichtung 1 um den Leiter 2 erfolgt, wie in Fig. 2 dargestellt ist, bevorzugt derart, dass die Stirnseiten 16 des Trägerelements 4 orthogonal oder im Wesentlichen orthogonal zu einer Längsachse des Leiters 2 stehen. Die auf dem Trägerelement 4 angeordneten Magnetfeldsensoren 6 können auf einer Stirnseite 16 des Trägerelements 4 angeordnet sein oder sie können auf beiden Stirnseiten 16 verteilt, beispielsweise in Umfangsrichtung alternierend, angeordnet sein. Das Trägerelement 4 kann dabei, wie später in Bezug zu Fig. 6 beschrieben wird, an beiden Seiten angesetzte Spulenträgerelemente aufweisen.

Wie in Fig. 1 dargestellt ist, umfasst das Trägerelement 4 mehrere Bauteilbereiche 17, in denen jeweils einer der Magnetfeldsensoren 6 angeordnet ist. Diese Bauteilbereiche 17 sind als starre Bereiche des Trägerelements 4 ausgeführt, so dass bei einem axialen Auseinanderziehen des Trägerelements 4 keine Verbiegung innerhalb dieser Bauteilbereiche 17 auftritt. Dies ermöglicht es, Beschädigungen an den Magnetfeldsensoren 6 und/oder an ihren Verbindungen zu Leiterbahnen (hier nicht dargestellt) auf dem Trägerelement 4 zu vermeiden.

Das Trägerelement 4 umfasst weiterhin einen Biegeabschnitt 18, in welchem aufgrund von randseitigen Aussparungen 19 eine Breite des Trägerelements 4 reduziert ist. Aufgrund der reduzierten Breite im Biegeabschnitt 18 kann ein Verbiegen des Trägerelements 4 in axialer Richtung vereinfacht werden, da das Trägerelement 4 im Biegeabschnitt 18 besonders biegbar ist. Weiterhin sind im Biegeabschnitt 18 zwei als Durchgangslöcher ausgebildete Aussparungen 20 vorgesehen, welche mit den randseitigen Aussparungen 19 eine Biegelinie 35 definieren, um welche das Trägerelement 4 besonders leicht gebogen werden kann. Die Biegelinie 35 erstreckt sich hierbei in radialer Richtung durch das Trägerelement 4. Zusätzlich oder alternativ zu den randseitigen Aussparungen 19 und/oder den als Durchgangslöchern ausgebildeten Aussparungen 20 kann in dem Biegeabschnitt 18 auch eine Dicke des Trägerelements 4, das heißt eine Ausdehnung des Trägerelements 4 in axialer Richtung, reduziert sein.

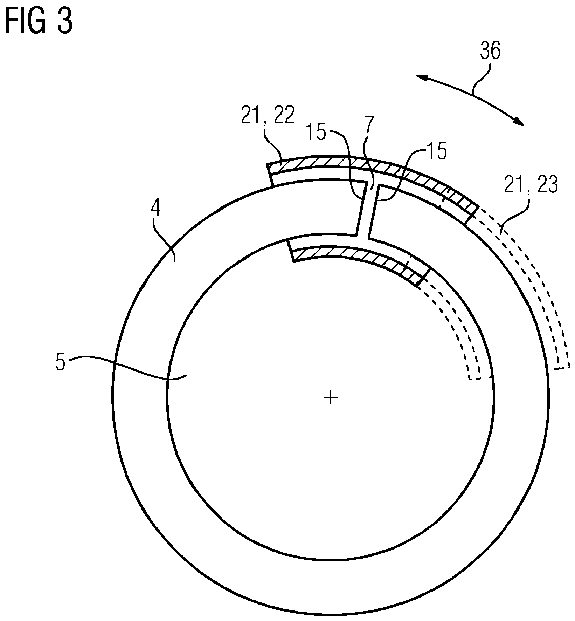

Um einen stabilen Sitz der Strommessvorrichtung 1 um den Leiter 2 zu gewährleisten, ist im Bereich der Durchbrechung 7 ein bewegbares Verschlusselement 21 vorgesehen. Das Verschlusselement 21 ist in Fig. 3 dargestellt. Das Trägerelement 4 entspricht der Ausführung in Fig. 1, es ist jedoch in Fig. 3 aus Übersichtlichkeitsgründen nur schematisch dargestellt. Das Verschlusselement 21 ist zwischen der gezeigten Schließstellung 22 und einer gestrichelt dargestellten Offenstellung 23 in Richtung des Pfeils 36 bewegbar. Das Verschlusselement 21 ist als hohles Kreisringsegment ausgeführt, in welchem das Trägerelement 4 sowie die das Trägerelement 4 umgebende Kompensationsspule 11 aufgenommen bzw. eingesteckt sind. Das Verschlusselement kann in der Offenstellung 23 und/oder der Schließstellung 22 verrasten, beispielsweise am Trägerelement 4 oder an einem Abdeckelement 33, wie es in Bezug zu Fig. 5 beschrieben wird. Es ist auch möglich, dass bei einem flexibel ausgebildeten Trägerelement 4 eine Offenstellung des Verschlusselements 21 dadurch erreicht wird, dass es an einer Seite von dem Trägerelement 4 abgezogen wird.

In Schließstellung 22 verhindert das Verschlusselement 21, dass die an die Durchbrechung 7 angrenzenden Kanten 15 des Trägerelements 4 relativ zueinander in Axialrichtung bewegbar sind. Bei Bewegung des Verschlusselements 21 in die Offenstellung 23 ist diese Blockierung aufgehoben, so dass die Kanten 15 des Trägerelements 4 in axialer Richtung bewegbar sind und die Strommessvorrichtung 1 um einen Leiter 2 angeordnet werden bzw. von einem Leiter 2 entfernt werden kann.

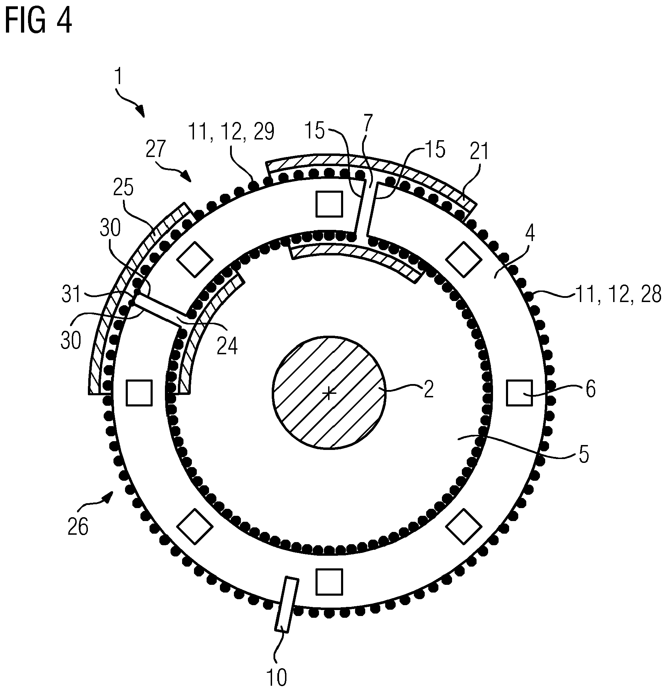

In Fig. 4 ist zweites Ausführungsbeispiel einer erfindungsgemäßen Strommessvorrichtung 1 dargestellt. Auf dem Trägerelement ist eine Mehrzahl von N = 6 Magnetfeldsensoren 6 angeordnet. Das Trägerelement 4 weist eine weitere Durchbrechung 24 auf. Im Bereich der weiteren Durchbrechung 24 ist ein weiteres Verschlusselement 25 angeordnet, welches entsprechend dem ersten Verschlusselement 21 zwischen einer Offenstellung und einer Schließstellung bewegt werden kann. Durch die weitere Durchbrechung 24 ist das Trägerelement 4 in zwei Segmente 26, 27 geteilt. Auch die um das Trägerelement 4 bzw. die Segmente 26, 27 des Trägerelements 4 angeordnete Kompensationsspule 11 ist in zwei Spulensegmente 28, 29 aufgeteilt. Dabei ist das Spulensegment 29 um das Segment 27 des Trägerelements 4 und das Spulensegment 28 um das Segment 26 des Trägerelements 4 herum angeordnet. Das im Bereich der weiteren Durchbrechung 24 angeordnete Verschlusselement 25 befestigt die Kanten 30 des Trägerelementes 4 in der dargestellten Schließstellung des weiteren Verschlusselements 25 derart, dass die Kanten 30 nicht relativ zueinander in axialer Richtung bewegbar sind.

Wenn das Verschlusselement 21 sowie das weitere Verschlusselement 25 jeweils in die Offenstellung bewegt werden, können die Segmente 26, 27 des Trägerelements 4 voneinander getrennt werden. Dies ermöglicht es, dass das Trägerelement um einen Leiter 2 herum angeordnet werden kann. Nach dem Anordnen eines der Segmente 26, 27 des Trägerelements 4 an dem Leiter 2 kann das andere der Segmente 26, 27 angesetzt und das Verschlusselement 21 sowie das weitere Verschlusselement 25 können von der Offenstellung in die Schließstellung bewegt werden. Bei diesem Ausführungsbeispiel einer Strommessvorrichtung 1 ist es nicht erforderlich, dass das Trägerelement 4 aus einem flexiblen Material besteht, da durch die Ausführung mit den zwei Segmenten 26, 27 auch bei einer starren Ausführung des gesamten Trägerelements 4 eine einfache Anordnung der Strommessvorrichtung 1 um den Leiter 2 herum ermöglicht wird.

Um die Spulensegmente 28, 29 elektrisch zur Kompensationsspule 11 zu verbinden, umfasst das weitere Verschlusselement 25 ein elektrisches Verbindemittel 31, mit welchem in Schließstellung des weiteren Verschlusselements 25 eine elektrische Verbindung zwischen dem Spulensegment 28 und dem Spulensegment 29 hergestellt wird.

Es ist möglich, dass die Kompensationsspule 11 im Bereich der Durchbrechung 7 und/oder der weiteren Durchbrechung 24 eine erhöhte Windungsdichte aufweist, um einen störenden Einfluss der unterbrochenen Führung der Windungen 12 aufgrund der Durchbrechung 7 und/oder der weiteren Durchbrechung 24 auf das von der Kompensationsspule 11 erzeugte Magnetfeld und somit auf die Strommessung durch die Magnetfeldsensoren 6 zu kompensieren. Eine erhöhte Windungsdichte bedeutet dabei, dass die Windungen 12 im Bereich der Durchbrechung 7 bzw. der weiteren Durchbrechung 24 in Umfangsrichtung näher beieinanderliegen als im restlichen Bereich der Kompensationsspule 11. Der Bereich mit der erhöhten Windungsdichte kann bezogen auf den Mittelpunkt der Durchbrechung 7 bzw. der weiteren Durchbrechung 25 einen Bereich von +/- 10° oder +/- 15° umfassen.

In Fig. 5 ist ein drittes Ausführungsbeispiel einer erfindungsgemäßen Strommessvorrichtung 1 dargestellt. In diesem Ausführungsbeispiel ist der in der Öffnung 5 angeordnete Leiter 2 als ein Leiterbündel ausgeführt. Gegenüberliegend der Durchbrechung 7 ist ein Bauteilbereich 17 des Trägerelementes 4 vorgesehen, in dem mehrere elektronische Bauteile 32 angeordnet sind. Bei den Bauteilen 32 handelt es sich um elektrische Bauteile einer Ansteuerungs- und Ausleseschaltung der Strommessvorrichtung 1 zur Ansteuerung und zum Auslesen der Magnetfeldsensoren 6 sowie der Kompensationsspule 11. Der Bauteilbereich 17 kann als Fläche, die die Bauteile 32 trägt, herausragen.

Der Bauteilbereich 17 ist als ein starrer Bereich des Trägerelements 4 ausgeführt, wobei die Bereiche außerhalb des Bauteilbereichs 14 des Trägerelements 4 als flexible Bereiche ausgeführt sind, so dass die Strommessvorrichtung 1, wie vorangehend beschrieben wurde, um den Leiter 2 angeordnet werden kann. Weiterhin ist ein schlauchförmiges Abdeckelement 33 vorgesehen, welches die Windungen 12 der Kompensationsspule 11 nach außen hin umschließt und somit für einen Schutz bzw. eine Isolierung der Kompensationsspule 11 dient. Bei herausragendem Bauteilbereich 17 kann das Abdeckelement 33 eine Öffnung aufweisen oder aber auch den herausragenden Anteil und die Bauteile 32 umgeben.

Auch in diesem Ausführungsbeispiel weist die Kompensationsspule 11 im Bereich der Durchbrechung 7 eine erhöhte Windungsdichte auf.

In Fig. 6 ist ein Querschnitt durch ein viertes Ausführungsbeispiel einer Strommessvorrichtung 1 dargestellt. In diesem Ausführungsbeispiel ist auf den Stirnseiten 16 des Trägerelements 4 jeweils ein Spulenträgerelement 34 angeordnet, um welches die Windungen 12 der Kompensationsspule 11 gewickelt sind. Die Spulenträgerelemente 34 weisen dabei eine im Wesentlichen halbkreisförmige Querschnittsfläche auf, welche zusammen mit der rechteckigen Querschnittsfläche des Trägerelements 4 eine im Wesentlichen kreisförmige Querschnittsfläche bilden, um welche die Windungen 12 der Kompensationsspule 11 gewickelt sind.

Die Spulenträgerelemente 34 weisen dabei eine mit der Durchbrechung 7 vollständig überlappende Durchbrechung auf, so dass die Strommessvorrichtung 1, wie vorangehend beschrieben wurde, um einen Leiter 2 herum angeordnet werden kann. Die jeweils auf einer Stirnfläche 16 angeordneten Spulenträgerelemente 34 können aus einem flexiblen Material, beispielsweise aus Silikon, gefertigt und mit dem Trägerelement 4 vergossen sein.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Strommessvorrichtung (1) zur Messung eines elektrischen Stroms in einem Leiter (2), umfassend eine Mehrzahl von Magnetfeldsensoren (6), welche in Umfangsrichtung auf einem im Wesentlichen ringförmigen Trägerelement (4) um eine vom Trägerelement (4) umgriffene Öffnung (5) zur Aufnahme des Leiters (2) angeordnet sind, **dadurch gekennzeichnet, dass** das Trägerelement (4) eine sich von einem äußeren Rand (8) des Trägerelements (4) zu der innenliegenden Öffnung (5) erstreckende Durchbrechung (7) aufweist.

2. Strommessvorrichtung nach Anspruch 1, **dadurch gekennzeichnet, dass** das Trägerelement (4) zumindest bereichsweise aus einem flexiblen Material, insbesondere aus Polyimid, besteht und/oder dass das Trägerelement (4) eine flexible oder teilflexible Leiterplatte ist.

3. Strommessvorrichtung nach Anspruch 1 oder 2, **dadurch gekennzeichnet, dass** das Trägerelement (4) wenigstens einen sich in Umfangsrichtung erstreckenden Biegeabschnitt (18) aufweist, in welchem eine radiale Breite und/oder eine Dicke des Trägerelements (4) reduziert ist und/oder in dem eine oder mehrere wenigstens eine Biegelinie (35) definierende Aussparungen (19, 20) vorgesehen sind.

4. Strommessvorrichtung nach einem der vorangehenden Ansprüche, **dadurch gekennzeichnet, dass** das Trägerelement (4) wenigstens einen starren, sich in Umfangsrichtung erstreckenden Bauteilbereich (17) aufweist, wobei in dem Bauteilbereich (17) wenigstens ein elektronisches Bauteil angeordnet ist.

5. Strommessvorrichtung nach einem der vorangehenden Ansprüche, dass die Mehrzahl von Magnetfeldsensoren (6) gleichmäßig in Umfangsrichtung auf dem Trägerelement (4) angeordnet sind, wobei die Durchbrechung (7) von einem der Magnetfeldsensoren bezogen auf den Mittelpunkt (3) der Öffnung (5) um den Winkel α = 90°/ N versetzt ist, wobei N die Anzahl der Magnetfeldsensoren (6) darstellt.

6. Strommessvorrichtung nach einem der vorangehenden Ansprüche, **dadurch gekennzeichnet, dass** sie wenigstens einen randseitig am Trägerelement (4) angeordneten Anschluss (10) aufweist, insbesondere in einem der Durchbrechung (7) gegenüberliegenden Bereich des Trägerelements (4).

7. Strommessvorrichtung nach einem der vorangehenden Ansprüche, **dadurch gekennzeichnet, dass** an dem Trägerelement (4) eine ringförmige, sich in Umfangsrichtung um die Öffnung (5) des Trägerelements (4) erstreckende, mehrere Windungen (12) umfassende Kompensationsspule (11) angeordnet ist, wobei sich die Kompensationsspule (11) entlang des Trägerelements (4) von einem ersten Ende (17) zu einem zweiten Ende (18) erstreckt, wobei das erste Ende (17) und das zweite Ende (18) jeweils auf einer gegenüberliegenden Seite der Durchbrechung (7) angeordnet sind.

8. Strommessvorrichtung nach Anspruch 7, **dadurch gekennzeichnet, dass** die Kompensationsspule (11) zu beiden Seiten der Durchbrechung (7) bereichsweise eine höhere Windungsdichte als im restlichen, wenigstens die Hälfte der Länge der Kompensationsspule (11) umfassenden und sich mittig zwischen den Enden (17, 18) der Kompensationsspule (11) erstreckenden Bereich der Kompensationsspule (11) aufweist.

9. Strommessvorrichtung nach einem der Ansprüche 7 oder 8, **dadurch gekennzeichnet, dass** die Kompensationsspule (11) zumindest im Wesentlichen toroidförmig ist, wobei die Windungen (12) der Kompensationsspule (11) durch Aussparungen des Trägerelements (4) geführt sind und/oder um das Trägerelement (4) gewickelt sind.

10. Strommessvorrichtung nach einem der Ansprüche 7 bis 9, **dadurch gekennzeichnet, dass** auf den gegenüberliegenden Stirnseiten (16) des Trägerelements (4) jeweils wenigstens ein flexibles, ringsegmentförmiges Spulenträgerelement (34) angeordnet ist, wobei die Kompensationsspule (11) jeweils um die Spulenträgerelemente (34) gewickelt ist, und/oder dass die Kompensationsspule (11) von einem flexiblen, schlauchförmigen Abdeckelement (33) umschlossen ist, welches sich in Umfangsrichtung von dem ersten Ende (17) zum zweiten Ende (18) der Kompensationsspule (11) erstreckt.

11. Strommessvorrichtung nach einem der vorangehenden Ansprüche, **dadurch gekennzeichnet, dass** an dem Trägerelement (4) im Bereich der Durchbrechung (7) ein bewegbares Verschlusselement (21) angeordnet ist, welches zwischen einer Offenstellung (23) und einer Schließstellung (22) bewegbar ist, wobei in der Offenstellung (23) die die Durchbrechung (7) begrenzenden Kanten (15) des Trägerelements (4) relativ zueinander bewegbar sind und in der Schließstellung (22) die die Durchbrechung (7) begrenzenden Kanten (15) des Trägerelements (4) relativ zueinander fixiert sind.

12. Strommessvorrichtung nach Anspruch 11, **dadurch gekennzeichnet, dass** das Trägerelement (4) wenigstens eine weitere, sich von einem äußeren Rand (8) des Trägerelements (4) zu der innenliegenden Öffnung (5) erstreckende Durchbrechung (24) aufweist, wobei an der wenigstens einen weiteren Durchbrechung (24) jeweils ein weiteres Verschlusselement (25) angeordnet ist.

13. Strommessvorrichtung nach Anspruch 12, **dadurch gekennzeichnet, dass** das weitere Verschlusselement (25) oder die weiteren Verschlusselemente (25) jeweils wenigstens ein elektrisches Verbindemittel (31) aufweist oder aufweisen, welches dazu ausgebildet ist, in Schließstellung des jeweiligen Verschlusselements (25) zwei benachbarte Spulensegmente (28, 29) einer Kompensationsspule (11) der Strommessvorrichtung (1) elektrisch zu verbinden.
